# DEMANDE DE BREVET EUROPEEN

(11) **EP 2 631 849 A1**
(43) Date de publication de la demande: **28.08.2013**
(21) Numéro de dépôt: 12305229.2
(22) Date de dépôt: 27.02.2012
(51) Int. Cl.: G06K 19/077

(54) **Procédé de fabrication d'un dispositif comprenant un module doté d'un circuit électrique et/ou électronique**

(71) Demandeur: Gemalto SA, 92190 Meudon (FR)
(72) Inventeur: Ottobon, Stéphane, 83270 SAINT CYR SUR MER (FR); Fidalgo, Jean-Christophe, 13420 Gemenos (FR); Dossetto, Lucile, 83270 Saint Cyr sur Mer (FR)

(57) **Abrégé**

Procédé de fabrication d'un dispositif comprenant un module doté d'un circuit électrique et/ou électronique

L'invention concerne un procédé pour la fabrication d'un dispositif électrique et/ou électronique comportant ou constituant un module électrique et/ou électronique (27), ledit procédé comprenant les étapes selon lesquelles :
- le module est doté d'au moins un premier circuit (28) disposé sur ou au-dessus d'un substrat (20) dans une zone d'enrobage (14E) occupant partiellement une surface du substrat,
- ledit premier circuit est enrobé au moins partiellement par une matière de protection (14) dans ladite zone d'enrobage,
- le module est doté de plots de connexion (34) destinés à connecter de manière permanente ledit premier circuit à un second circuit (31) externe au module ;

Le procédé se distingue en ce qu'il comprend l'étape de réalisation des plots de connexion (34) dans la zone d'enrobage (14E).

L'invention concerne également un dispositif correspondant au procédé.

## Description

### Domaine de l'invention.

L'invention concerne un procédé de fabrication d'un dispositif comprenant ou constituant un module doté d'au moins un premier circuit électrique et/ou électronique ; Le circuit électrique est complété de préférence par au moins une puce de circuit intégré.

Il concerne en particulier des dispositifs électroniques multi-composants comportant un tel module. De tels dispositifs peuvent comporter des composants électroniques divers tels que par exemple un afficheur, un clavier, une batterie, etc. ; Ces dispositifs peuvent générer des fonctions telles que génération d'un numéro à usage unique (OTP), permettre d'afficher les dernières transactions bancaires effectuées, tout en associant des fonctions standard de type paiement, transport, identification...

L'invention peut concerner notamment le domaine des supports électroniques tels que cartes à puce à contacts ou sans contact ou cartes hybrides, tickets ou étiquettes radiofréquences, transpondeurs radiofréquences, inserts (ou inlay) intégrant ou constituant un tel module.

De tels supports électroniques peuvent être conformes notamment au standard ISO / IEC 14443 ou ISO 78016.

Le terme circuit électrique signifie tout ou partie d'éléments conducteur de courant électrique notamment des plages de contacts électriques, des pistes conductrices, des connexions, des pistes de redirection, des plots électriques associés ou non à au moins un circuit intégré ou composant électronique / électrique (capacité, bobine, résistance...) connecté à ce circuit électrique. Les puces de circuit intégré sont celles connues du domaine de la carte à puce, notamment puce à interface duale (contact et sans contact), diode électroluminescente, capteur audio, microcontrôleur, contrôleur de communication notamment de champ radiofréquence de proximité NFC (Near field communication)

### Art antérieur.

Il est connu de fabriquer un module de carte à puce par les étapes ci-après.
- réalisation de pistes ou plages conductrices sur un support continu diélectrique ou isolant,
- report d'au moins une puce de circuit intégré sur le support ou les plages,
- connexion de la puce aux pistes ou plages conductrices notamment par fil soudé, colle conductrice,
- enrobage d'au moins la puce et/ou ses connexions par une résine de protection dans une zone d'enrobage autour de la puce.

Le brevet US 5 598 032 décrit un procédé d'assemblage d'un module destiné à se connecter à une antenne noyée dans un corps support de carte à puce hybride (contact et sans contact), il est connu de ménager une cavité dans le corps support de manière à rendre les plages de connexion de l'antenne accessibles pour une connexion avec le module lors de son report dans la cavité. Des éléments d'interconnexion conducteurs de toute sorte peuvent relier des zones de connexion du module disposées en dehors de l'enrobage et les plages de connexion de l'antenne.

Le brevet FR 2 847 365 décrit la réalisation de plots d'interconnexion ou excroissances conductrices sur un module. Ces excroissances transpercent une couche d'adhésif isolant thermo activable couvrant toute la surface inférieure du module et destinée à faire adhérer le module contre au moins un contact conducteur.

Problème technique.

Les modules intégrant une puce notamment pour carte multi-composants, par exemple à écran, nécessitent d'être connectées électriquement à un circuit contenu dans la carte. Actuellement ces connexions suivant l'axe Z perpendiculairement à la surface principale de la carte sont situées sur la surface de collage d'un module du type à double face. Ceci a pour effet de diminuer la surface spécifique au collage et ainsi diminuer l'adhésion du module sur la carte et cela d'autant plus qu'il y a beaucoup de connexions à réaliser (par exemple huit, lorsqu'on a une carte à écran / antenne / boutons / batterie). Et cette adhésion est très importante dans ce type de carte car elle assure le maintien et donc la fiabilité des connexions par plots ou excroissances flexibles de colle conductrice.

### Résumé de l'invention.

L'invention consiste à réaliser des plots de connexion du module destinés à connecter un circuit externe au module, dans une zone d'enrobage du circuit électrique et/ou électronique du module tout en libérant de la surface de fixation du module située en périphérie de cette zone d'enrobage.

L'invention a donc pour objet u n procédé pour la fabrication d'un dispositif électrique et/ou électronique comportant ou constituant un module électrique et/ou électronique, ledit procédé comprenant les étapes selon lesquelles :
- le module est doté d'au moins un premier circuit disposé sur ou au-dessus d'un substrat dans une zone d'enrobage occupant partiellement une surface du substrat,
- ledit premier circuit est enrobé au moins partiellement par une matière de protection dans ladite zone d'enrobage,
- le module est doté de plots de connexion destinés à connecter de manière permanente ledit premier circuit à un second circuit externe au module,

Le procédé se distingue en ce qu'il comprend l'étape de réalisation des plots de connexion dans la zone d'enrobage.

Selon une caractéristique préféré de l'invention, le dispositif à réaliser comporte un corps-support muni d'au moins une cavité ménagée dans un corps-support ainsi que le module fixé dans la cavité ; Le procédé se distingue en ce qu'il comprend les étapes suivantes de :
- formation d'un corps-support ayant des bornes d'un second circuit incorporées dans le corps-support et au moins une cavité ménagée au-dessus des bornes de connexion dudit second circuit de manière à révéler ou faire déboucher lesdites bornes ou les rendre accessibles,
- report du module dans la cavité, le premier circuit connectant lesdites bornes du second circuit.

D'autres caractéristiques et mode de mise en oeuvre font l'objet des revendications 2 à 5.

L'invention a également pour objet un dispositif correspondant au procédé constituant ou comportant le module.

L'objet peut constituer de préférence une carte à plusieurs composants intégrant l'un des composants tels que : un afficheur avec ou sans son circuit de pilotage, un capteur d'empreinte digitale, un capteur d'une autre grandeur physique (rayonnement, température, analyse chimique...), une source d'énergie (cellule solaire, élément de collecte d'énergie, batterie primaire ou rechargeable...),

Le facteur de forme de la carte peut être celui d'une carte IDO, Plug-in UICC, d'un passeport électronique, d'un ticket d'épaisseur inférieure à 0.8 mm.

Brève description des figures.
- Les figures 1 et 2 illustrent un module de carte à puce de l'art antérieur respectivement en vue de dessus et en coupe ;
- La figure 3 illustre un module obtenu conformément à un mode de mise en oeuvre du procédé de l'invention ;
- La figure 4 est une vue en coupe partielle d'un dispositif comportant le module conforme à l'invention, reçu dans une cavité d'un corps support comportant le circuit multi-composants de la figure 5 ;
- La figure 5 illustre un corps-support conforme à un mode préféré de mise en oeuvre du procédé de l'invention ;
- La figure 6 illustre des étapes d'un mode de mise en oeuvre préféré du procédé de l'invention.

### Description.

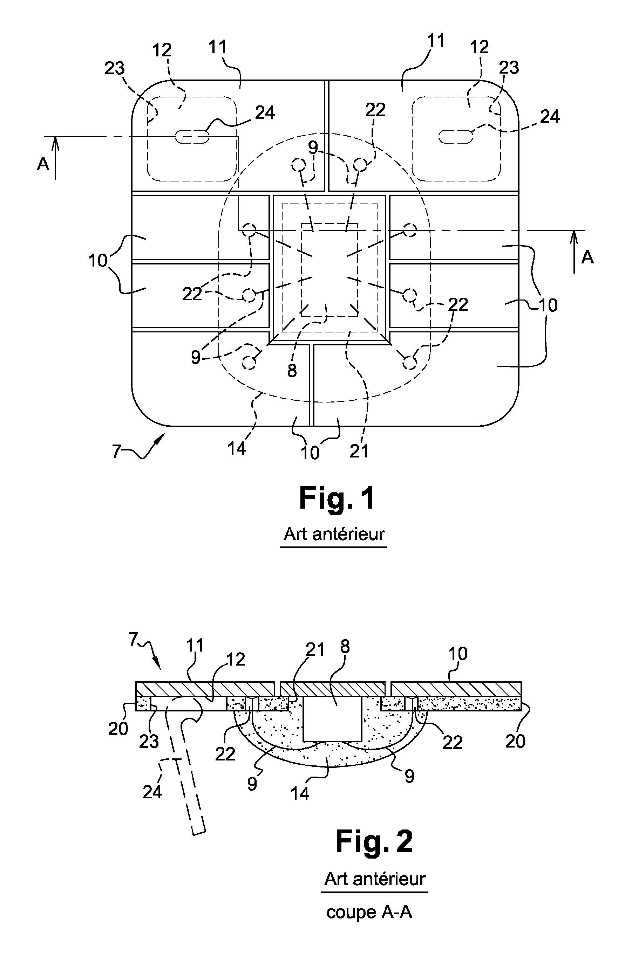

Les figures 1 et 2 illustrent un module 7 de carte à puce de circuit intégré hybride de l'art antérieur. Il comprend des plages de contact 10, 11 sur un support 20 diélectrique ou isolant notamment du type LFCC (Lead frame contrecollé), au moins une puce de circuit intégré 8 reportée sur le support 20 ou ici sur une plage métallique de contact ou non. Les plages de contact sont destinées à connecter un connecteur de lecteur de carte à puce.

Le module comprend également des connexions 9 pour notamment connecter des plages de contact par fils soudés, par colle conductrice ou autre, une puce pouvant être retournée (flip-chip) ou non ; Il comprend un enrobage de la puce et/ou de ses connexions par une matière de protection 14 telle une résine (glob-top), qui peut être déposée par exemple sous forme de goutte ou déposée par surmoulage.

Les connexions 9 connectent les plages de contact à travers des orifices 22 ménagés dans le support isolant.

La surface inférieure du module s'étendant sensiblement du bord de l'enrobage jusqu'au bord du module peut constituer une surface de collage du module sur un plan d'une cavité ménagée dans le corps de carte.

Le module comprend également des moyens de connexions 24 pour connecter une antenne noyée dans un corps de carte (non représenté) recevant le module. Ces moyens 24 connectent deux plages conductrices 11 du module à travers deux orifices 23 situés dans la surface de collage du module sur le corps de carte ou du moins en dehors de la matière de protection 14. Ces deux plages 11 sont connectées aux plots radiofréquences de la puce, ici par fils soudés à travers des orifices 23.

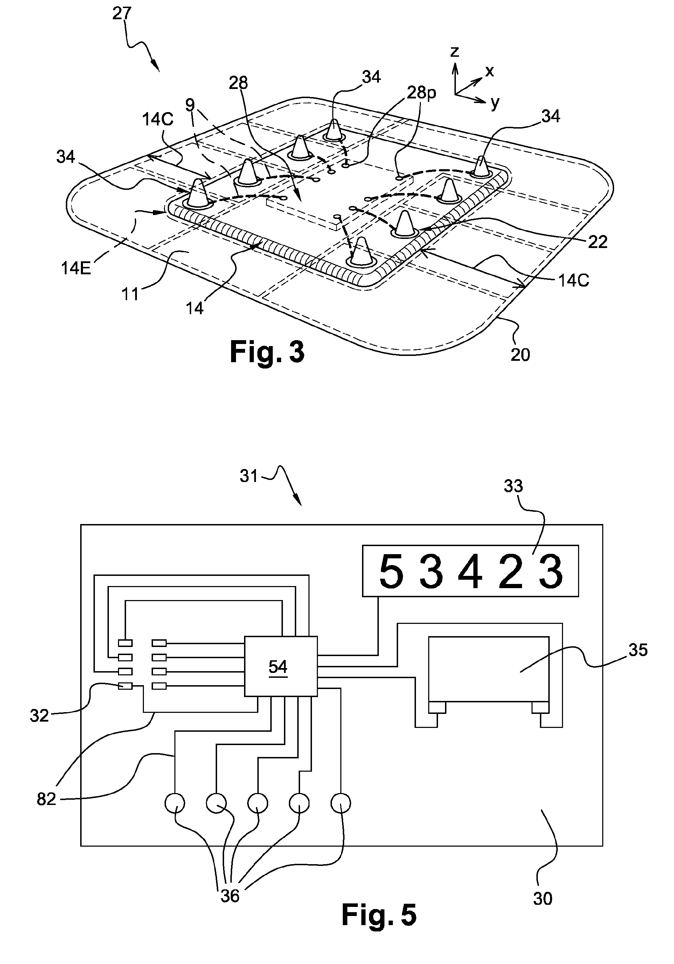

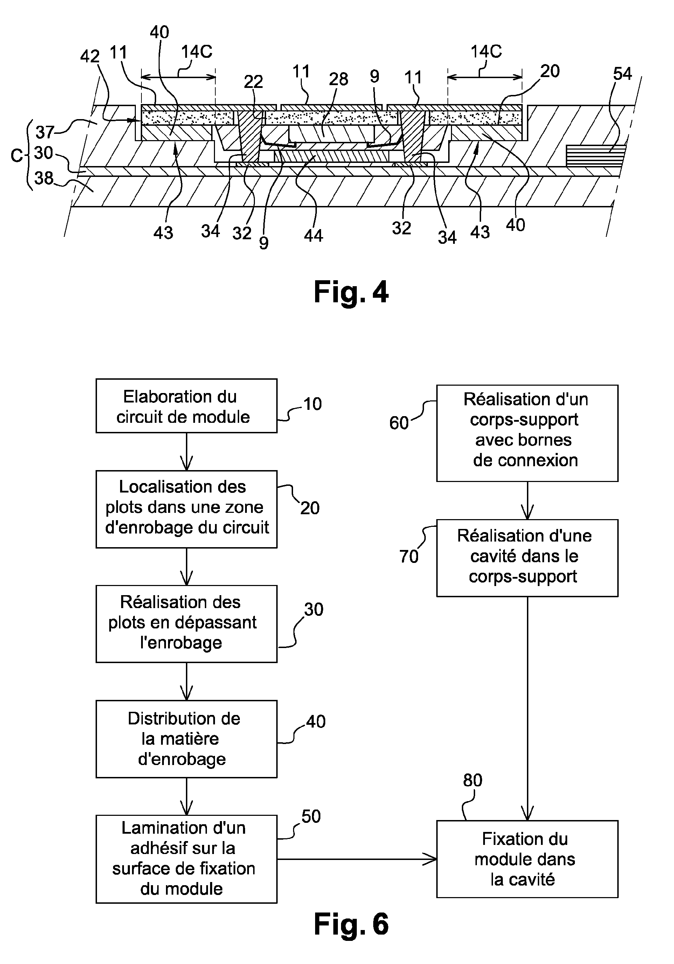

Les figures 3 et 4 illustrent un dispositif électronique comportant un module 27 à puce 28 obtenu par un premier mode de mise en oeuvre du procédé de l'invention. Les mêmes références d'une figure à l'autre indiquent des moyens identiques ou similaires.

Le module 27 à puce à circuit intégré ou électronique 28, peut être sensiblement du même type que sur la figure précédente ; Il comprend un substrat 20 et une matière de protection 14 enrobant au moins partiellement le circuit électronique 28 dans une zone d'enrobage 14E.

Dans une variante de l'invention, on pourra envisager l'absence de substrat 20, les plages étant alors maintenues ensemble via un enrobage ou une résine. Aussi dans certains cas, l'enrobage peut recouvrir des parties conductrices qui sont situées sur le substrat isolant, dans le cas, par exemple où l'élément 22 serait une plage métallique d'un module à double face métallisée.

La zone d'enrobage est entourée par une surface périphérique 14C de fixation du module ou de collage. Cette surface périphérique 14C est de préférence d'une largeur sensiblement constante autour de l'enrobage et est destinée à adhérer à un corps-support décrit ultérieurement soit directement soit via un moyen de fixation tel un adhésif. Il convient d'avoir cette surface suffisamment grande pour satisfaire des critères d'adhérence et/ou des critères d'anti-arrachement du module, contrôlés au cours de tests appropriés.

La puce électronique 28 connecte des plages de contact 11 à travers des orifices 22 par tout moyen connu et en l'occurrence par des fils soudés

Le module peut comporter ou non la puce 28, celle-ci pouvant être déportée ou substituée par un autre composant à enrober ; Le module peut comporter simplement des plots à isoler par un enrobage (par exemple deux plots ou de préférence plus que deux). L'enrobage apporte aussi un renfort mécanique de ce module à plots, par exemple dans le cas d'un module qui ne possède pas d'électronique mais qui interface un élément de la carte avec l'extérieur. La puce 28 peut ou non réaliser des fonctions de communication avec un lecteur à contact. En fait, ces fonctions et/ou la puce peuvent être déportées dans un dispositif support tel un corps-support de carte ou autre.

Le module peut comporter par exemple au moins une puce de capteur d'empreinte ou autre moyen d'authentification, de température, une diode réceptrice et/ou émettrice...

Le module peut comporter uniquement des plots reliant des pistes ou des plages conductrices du module par exemple pour une redirection ou activation de tout ou partie du circuit électronique d'un corps-support associé.

Le module peut être ou non noyé dans un corps-support ou corps contenant le circuit 32 et/ou autre composants. (Cas d'un module sans plages conforme à l'ISO 7816)

Selon une caractéristique d'un mode préféré de l'invention, des plots de connexion 34 du module font saillie de la surface d'enrobage vers l'extérieur du module. Ils s'étendent ici perpendiculairement (axe Z) par rapport au plan principal du module (X, Y). Ces plots connectent, dans cet exemple, des plages de connexion 11 du module auxquelles est reliée la puce de circuit intégré.

Avantageusement, on partage les orifices 22 pour connecter la puce et connecter les plots 34 aux plages mais ce n'est pas obligatoire. Les plots peuvent avoir ou non leur orifice dédié exclusif. Avantageusement, la matière conductrice des plots enrobe le fil conducteur et améliore la solidité de la connexion à la puce.

Selon ce premier mode préféré, le procédé pour la fabrication du dispositif électronique ci-dessus se distingue par une étape de réalisation des plots de connexion dans la zone d'enrobage 14E.

De préférence, les plots ou excroissances 34 sont d'abord réalisés de manière connue en étant au contact des surfaces de connexion du module ou plages de contact 11. Ensuite, on peut réaliser l'enrobage 14 notamment par dépôt de résine sur la puce de circuit intégré. Ici, les fils soudés de connexion reliant la puce sont également enrobés.

Le cas échéant, on peut surmouler ou utiliser un cadre ou barrière autour des plots pour délimiter l'étendue de l'enrobage. Le cadre peut rester à demeure sur le module ou être retiré ultérieurement. Les excroissances dépassent la surface externe de l'enrobage.

Alternativement, comme les plots enrobent en partie une extrémité des fils soudés, la matière d'enrobage peut s'étendre jusqu'aux plots seulement sans les entourer complètement.

Selon un mode de mise en oeuvre du procédé, l'invention prévoit une étape de fixation du module dans ou sur un corps-support comportant des points de connexions 32 ; La fixation peut s'effectuer par une adhésion d'au moins une surface entourant l'enrobage sur une surface du corps-support 30 située en dehors de l'enrobage. Le corps-support 30 est décrit ultérieurement ; Il peut comprendre ou constituer des moyens électroniques illustrés aux figures 4 et 5.

Selon une autre étape d'un mode de mise en oeuvre du procédé de l'invention, il est prévu une étape de réalisation d'un circuit électronique 31 (figure 5) à plusieurs composants dans ou sur le corps-support isolant 30 ; Le circuit 31 est conçu de manière à relier des plages de connexion 32 du circuit regroupées dans une zone de report du module de manière à le connecter.

Le circuit peut comprendre plusieurs composants dans ou sur un corps-support. Le circuit comprend ici par exemple un afficheur 33, un microcontrôleur 54, une batterie 35, des boutons ou clavier 36 et au moins des plages de connexion 32 reliant les composants du circuit notamment par des pistes d'interconnexion ou de liaison 82. Le cas échéant, le circuit peut être composé uniquement par des plages de connexions 32 ; celles-ci peuvent par exemple servir à effectuer une redirection du circuit électronique.

Le cas échéant, le corps-support peut comporter une antenne radiofréquence. Le corps-support peut comporter seul ou en association plusieurs composants ci-dessus ou autres composants, microphone, haut-parleur...

Selon un mode de mise en oeuvre, le procédé de l'invention prévoit d'associer le module avec un corps support (figure 4) ; Le procédé prévoit à cet effet une étape de connexion des plots ou excroissances à des plages de connexion 32 du corps-support notamment les plages de connexion du circuit.

Cette connexion peut s'effectuer par exemple par collage des excroissances du module aux plages de connexion 32. La colle choisie sera alors chargée de particules conductrices.

Si le matériau constituant les excroissances présente une forte élasticité, on pourra envisager de seulement maintenir en pression ces excroissances sur les plages de connexion 32 pour assurer le contact.

En variante, le procédé peut prévoir des liaisons filaires (soudure) entre des plots métalliques à connecter (saillants ou non par rapport à la surface de l'enrobage) disposées à l'intérieur de la zone d'enrobage et des bornes du corps-support.

Alternativement, de préférence, l'invention prévoit que l'étape de connexion des plots du module à des plages de connexion du corps-support s'effectue au cours de la fixation du module sur une surface 43 du corps-support. Ainsi, grâce à l'invention, on augmente la surface de fixation du module hors enrobage.

Dans l'exemple, le module est un module du type carte à puce 27 avec des plages de contact destinées à connecter un lecteur de carte à contacts.

Le corps-support 31 peut être un corps de carte à puce comportant le substrat 30 ou un dispositif similaire. Le module est reporté de préférence dans une cavité 42 du corps-support. Le corps-support comprend à la figure 4 une couche supérieure 37 et inférieure 38. Ces couches peuvent être obtenues par surmoulage de matière ou lamination de feuilles isolantes.

Selon une caractéristique du procédé de l'invention, on prévoit d'effectuer l'étape de connexion du module aux plages de connexion au cours de l'étape de fixation du module sur ladite surface du corps 43.

Dans l'exemple, les plages de connexion sont accessibles directement par les plots, lors du report du module dans la cavité 42 ménagée dans le corps-support (C). Le module est fixé ici par un adhésif 40 du type thermo-adhésif (hotmelt).

Le cas échéant, on peut améliorer l'adhésion on ajoutant un point de colle ou adhésif 44 au fond de la cavité pour adhérer à l'enrobage 14.

La figure 6 illustre les étapes d'un mode préféré de mise en oeuvre de l'invention pour réaliser une carte multi-composants.

A l'étape 10, (Elaboration du premier circuit conducteur de module) l'invention réalise un module 27 notamment du type carte à puce, avec des emplacements de multiples excroissances en Z (perpendiculairement à une surface principale du module) ou points de connexion 34 destinées à pointer vers un second circuit 31, notamment flexible, multi-composants (ou autre dispositif à circuit électronique).

Malgré la présence de plus de deux plots conducteurs 34 pour relier un second circuit externe au module, le module est réalisé de manière à préserver l'intégralité de la surface de fixation 14C autour d'une zone d'enrobage 14E. La préservation de l'intégralité de la surface de collage permet de garantir la meilleure fiabilité possible des connexions pour des cartes multi-composants.

A l'étape 20, (localisation des plots dans zone d'enrobage), le procédé dispose les plots de connexions 34 (orientés selon l'axe Z du module) à l'intérieur de la surface d'enrobage 14E destinée à recevoir la matière d'encapsulation ou d'enrobage.

Plus précisément, dans l'exemple préféré, les plots se situent au dessus et à l'aplomb des puits de connexion 22. Les puits sont destinés à relier (par fils 9 en or) les plots conducteurs 28P de la puce aux différentes plages de contact 11 du module. Le premier circuit comprend les plots et des plages conductrices avec le cas échéant des pistes conductrices pouvant relier des plages conductrices.

A l'étape 30, (Réalisation de plots conducteurs dépassant l'enrobage) les plots 34 sont réalisées par des excroissances de colle conductrice flexible (Bumps en anglais) avec une hauteur plus importante que celle de l'enrobage (Ces plots peuvent par exemple être flexibles, élastiques, en étant réalisés avec de la colle argent à base de silicone). La hauteur de ces excroissances est ajustée pour avoir une certaine compression à obtenir un effet ressort et donc à garantir la connexion.

A l'étape 40, (Distribution de la matière d'enrobage), le procédé distribue une matière d'enrobage ou d'encapsulation 14 autour des plots sans dépasser la zone d'enrobage 14E. Le trajet de distribution de la matière permet de préférence de faire fluer la résine d'encapsulation autour des excroissances conductrices en les laissant dépasser.

Alternativement, on peut d'abord réaliser l'enrobage puis les plots dans l'enrobage. On choisira alors de préférence un procédé de moulage pour assurer cet enrobage. Le moule sera conçu en prévoyant des parties en contact avec les plages de connexion de façon à prévenir le recouvrement de ces plages par de la résine. Cela permettra de réaliser directement des puits en regards des plages de connexion sans nécessiter d'étape supplémentaire d'usinage ou fraisage. On pourra alors réaliser ensuite les plots dans les puits de l'enrobage.

L'enrobage étant formé, on peut usiner des trous dedans (notamment par forage ou laser) à l'emplacement prévu des plots et réaliser les plots comme précédemment dans les trous.

A l'étape 50 (lamination d'un adhésif de fixation), le module est préalablement laminé sur la totalité de sa surface de collage avec un adhésif thermo-adhésif (hotmelt) ; Alternativement, le module peut être fixé sans matière adhésive intermédiaire. Par exemple, le film diélectrique du module peut adhérer lui-même directement à la matière du corps support notamment par thermo compression.

A l'étape 60, (Réalisation d'un corps-support) le procédé prévoit de réaliser un second circuit conducteur comportant au moins des plages de connexion 32 et/ou pistes conductrices destinées à connecter les plots du module. Le second circuit est de préférence compris dans un corps noyé dans des couches ou matières isolantes 37, 38.

A l'étape 70, (Réalisation d'une cavité), on réalise une cavité de réception du module dans le corps support de façon à laisser apparaitre les plages de connexions d'un circuit à connecter avec le module. Alternativement, on peut définir une surface de fixation correspondant à celle du module sans cavité, par exemple à la surface du corps-support. La cavité peut être obtenue en laminant ou fixant des feuilles entre-elles et comportant déjà des perforations.

A l'étape 80, (Fixation module) le module est ensuite reporté et collé par pressage thermo-activé dans une cavité du corps-support.

Ainsi, le collage du module est optimal et équivalent à celui d'un module qui n'aurait pas de connexions en Z, et les excroissances sont bien comprimées et maintenues contre les plages à connecter du corps-support.

Il n'y a donc pas de dégradation de collage en réalisant un module avec de multiples connexions en Z vers le support flexible. Dans une variante de l'invention, l'excroissance de colle conductrice peut encapsuler une partie du fil or en connectant la puce.

Bien que décrit en rapport avec une carte multi-composants, le procédé de l'invention peut contribuer à l'obtention de tout objet portable électronique comportant le module décrit ci-dessus.

Alternativement, les plots peuvent être réalisés sur des plages de connexion du corps-support au lieu du module comme dans le brevet EP1567979 ou bien en partie sur le module et en partie sur le corps-support. Les plots ou points de connexion du module sont ici toujours contenus dans la zone d'enrobage 14E. Alternativement, les plots sont disposés à la limite de la zone d'enrobage ; ils peuvent ainsi contribuer à limiter l'étendue de la résine.

Les plots du corps-support viennent connecter des plages de connexion du module notamment lors de l'assemblage. En variante, les plots ne dépassent pas vraiment l'enrobage ; Ils peuvent remplir tout ou partie des orifices 22.

Selon une variante (non représentée), l'invention prévoit de réaliser une cavité dite seconde, entre les bornes 32 de manière à recevoir au moins une partie de l'enrobage. De préférence, aucune piste de raccordement ne s'étend dans une zone comprise pour permettre une cavité à travers le support 30 du corps-support 31 et le cas échéant aussi en partie dans la feuille 38.

## Revendications

1. Procédé pour la fabrication d'un dispositif électrique et/ou électronique comportant ou constituant un module électrique et/ou électronique (27), ledit procédé comprenant les étapes selon lesquelles :
- le module est doté d'au moins un premier circuit (28) disposé sur ou au-dessus d'un substrat (20) dans une zone d'enrobage (14E) occupant partiellement une surface du substrat,
- ledit premier circuit est enrobé au moins partiellement par une matière de protection (14) dans ladite zone d'enrobage,
- le module est doté de plots de connexion (34) destinés à connecter de manière permanente ledit premier circuit à un second circuit (31) externe au module,
**caractérisé en ce qu'**il comprend l'étape de réalisation des plots de connexion (34) dans la zone d'enrobage (14E).

2. Procédé selon la revendication précédente, **caractérisé en ce qu'**il comporte l'étape de fixation du module dans ou sur un corps support (30), la fixation s'effectuant par une adhésion d'au moins une surface périphérique (14C) entourant l'enrobage sur une surface correspondante (43) du corps support.

3. Procédé selon l'une des revendications précédentes, **caractérisé en ce qu'**il comporte une étape de réalisation d'au moins des bornes de connexion (32) d'un second circuit électrique (31) ou à plusieurs composants dans ou sur le corps-support (30).

4. Procédé selon la revendication précédente, **caractérisé en ce qu'**il comporte une étape de connexion des plots (34) à des bornes de connexion (32) du corps-support.

5. Procédé selon la revendication précédente, **caractérisé en ce que** l'étape de connexion du module aux bornes de connexion s'effectue au cours de la fixation du module sur ladite surface correspondante (43) du corps, les plots connectant lesdites bornes de connexion du corps-support.

6. Procédé pour la fabrication d'un dispositif électrique et/ou électronique selon la revendication 1, ledit dispositif comportant un corps-support (30) muni d'au moins une cavité (42) ménagée dans le corps-support et le module fixé dans la cavité, **caractérisé en ce qu'**il comprend les étapes suivantes de :
- formation d'un corps support (2) ayant lesdites bornes d'un second circuit (31) incorporées dans le corps-support et au moins une cavité (42) ménagée au-dessus des bornes de connexion (32) dudit second circuit de manière à révéler lesdites bornes (32) ou les rendre accessibles,
- report du module dans la cavité, le premier circuit connectant lesdites bornes du second circuit.

7. Procédé selon la revendication précédente, **caractérisé en ce qu'**il comporte une étape de réalisation d'une seconde cavité entre les bornes de connexion à travers le corps-support pour recevoir au moins en partie l'enrobage.

8. Dispositif électrique et/ou électronique comportant ou constituant un module électrique et/ou électronique (27),
- le module étant doté d'au moins un premier circuit (28) disposé sur ou au-dessus d'un substrat (20) dans une zone d'enrobage (14E) occupant partiellement une surface du substrat,
- ledit premier circuit étant enrobé au moins partiellement par une matière de protection (14) dans ladite zone d'enrobage,
- ledit module étant doté de plots de connexion (34) destinés à connecter de manière permanente ledit premier circuit à un second circuit (31) externe au module, **caractérisé en ce que** lesdits plots de connexion (34) sont réalisés dans la zone d'enrobage (14E).
